Europäisches Patentamt

European Patent Office

Office européen des brevets

(19)

(11) **EP 1 136 834 A2**

(12) **EUROPÄISCHE PATENTANMELDUNG**

(43) Veröffentlichungstag:
**26.09.2001  Patentblatt 2001/39**

(51) Int Cl.7: **G01R 31/3185**

(21) Anmeldenummer: **01104729.7**

(22) Anmeldetag: **26.02.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **23.03.2000  DE 10014386**

(71) Anmelder: **Infineon Technologies AG**
**81669 München (DE)**

(72) Erfinder:
• **Schneider, Ralf**
  **81925 München (DE)**
• **Schröder, Stephan, Dr.**
  **81543 München (DE)**

(74) Vertreter: **Epping Hermann & Fischer**
**Ridlerstrasse 55**
**80339 München (DE)**

(54) **Integrierte Schaltung mit Ansteuerungsschaltung zur Ansteuerung einer Treiberschaltung**

(57)      Eine integrierte Schaltung mit einem Anschluß (10) für ein digitales Signal (DQS) weist eine steuerbare Treiberschaltung (2) auf, an der das digitale Signal (DQS) anliegt, und die zur Ausgabe des digitalen Signals (DQS) dient. Mittels einer einstellbaren Ansteuerungsschaltung (3), die einen Eingang (31) für ein Taktsignal (CK) aufweist, wird die Treiberschaltung (2) in Abhängigkeit des Taktsignals (CK) angesteuert. Die integrierte Schaltung enthält außerdem eine Vergleichseinrichtung (4) zum zeitlichen Vergleich von Signalübergängen des Taktsignals (CK) mit Signalübergängen des digitalen Signals (DQS). Am Ausgang (43) der Vergleichseinrichtung (4) ist ein Ausgangssignal (A) abgreifbar. So ist in einem Testbetrieb ein zeitlicher Vergleich der Signalübergänge des Taktsignals (CK) und des digitalen Signals (DQS) am Ausgang der steuerbaren Treiberschaltung (2) mit einer vergleichsweise hohen Genauigkeit durchführbar.

FIG 1

EP 1 136 834 A2

**Beschreibung**

Die vorliegende Erfindung betrifft eine integrierte Schaltung mit einem Anschluß für ein digitales Signal, mit einer steuerbaren Treiberschaltung, die einen Eingang aufweist, der mit dem Anschluß für das digitale Signal verbunden ist, und einen Ausgang zur Ausgabe des digitalen Signals, und mit einer Ansteuerungsschaltung, die einen Eingang für ein Taktsignal aufweist, zur Ansteuerung der Treiberschaltung in Abhängigkeit des Taktsignals.

Im Betrieb von integrierten Schaltungen ist es häufig erforderlich, ein digitales Signal so zu erzeugen oder einzustellen, daß der Zeitpunkt einer Schaltflanke des digitalen Signals an einen Zeitpunkt einer Schaltflanke eines Taktsignals angepaßt ist. Beispielsweise wird das digitale Signal von einer Oszillatorschaltung erzeugt. Die Frequenz des von der Oszillatorschaltung erzeugten Signals ist dabei so einzustellen, daß sie mit der Frequenz des Taktsignals als Bezugsfrequenz übereinstimmt, insbesondere so genau, daß eine vorhandene Phasenverschiebung gleich bleibt.

Eine integrierte Schaltung weist zu diesem Zweck neben einem Anschluß für das digitale Signal beispielsweise eine steuerbare Treiberschaltung auf, die mit dem Anschluß für das digitale Signal verbunden ist, und die zur Ausgabe des digitalen Signals dient. Die Treiberschaltung wird dabei durch eine Ansteuerungsschaltung angesteuert, die einen Eingang für ein Taktsignal aufweist.

Die Ansteuerungsschaltung ist beispielsweise in einem gewissen Bereich anhand eines Referenzwertes einstellbar, um insbesondere Einflüsse von Prozeßschwankungen und Temperaturschwankungen kompensieren zu können. Das bedeutet, im Zuge der Herstellung von derartigen integrierten Schaltungen werden die jeweiligen Referenzwerte jeweils getrennt für jede der integrierten Schaltungen eingestellt und damit angepaßt. Dazu wird der Referenzwert in geeigneter Weise so verändert, daß die unterschiedlichen Einflüsse kompensiert sind. Die Ansteuerungsschaltung wird also ausgehend von dem Referenzwert derart getrimmt, so daß die erforderliche Signalsynchronisation eingestellt ist.

Zur Einstellung der Ansteuerungsschaltung wird die integrierte Schaltung, die beispielsweise Bestandteil eines integrierten Speichers ist, einem diesbezüglichen Test unterzogen. Dieser Test wird beispielsweise von extern mittels eines dafür vorgesehenen Testsystems durchgeführt. Anhand eines Testergebnisses werden Vorgaben zur Einstellung der Ansteuerungsschaltung definiert. Dazu werden die Schaltflanken des entsprechenden digitalen Signals und des Taktsignals miteinander verglichen und durch Einstellung der Ansteuerungsschaltung zeitlich abgeglichen. Die erreichbare Genauigkeit wird dabei im allgemeinen begrenzt durch Toleranzen des verwendeten Testsystems und der gesamten Testanordnung. Dies kann zur Folge haben, daß eine erforderliche Produktspezifikation der integrierten Schaltung und damit des integrierten Speichers nicht erfüllt ist.

Die Aufgabe der vorliegenden Erfindung ist es, eine integrierte Schaltung der eingangs genannten Art anzugeben, bei der in einem Testbetrieb ein zeitlicher Vergleich von Schaltflanken des Taktsignals und des digitalen Signals am Ausgang der steuerbaren Treiberschaltung mit einer vergleichsweise hohen Genauigkeit durchführbar ist.

Die Aufgabe wird gelöst durch eine integrierte Schaltung mit einem Anschluß für ein digitales Signal, mit einer steuerbaren Treiberschaltung, die einen Eingang aufweist, der mit dem Anschluß für das digitale Signal verbunden ist, und die einen Ausgang aufweist zur Ausgabe des digitalen Signals, und mit einer Ansteuerungsschaltung, die einen Eingang für ein Taktsignal aufweist, zur Ansteuerung der Treiberschaltung in Abhängigkeit des Taktsignals; bei der die integrierte Schaltung eine Vergleichseinrichtung aufweist, die einen ersten Eingang für das Taktsignal und einen zweiten Eingang aufweist, der mit dem Ausgang der Treiberschaltung verbunden ist, und die einen Ausgang aufweist zur Ausgabe eines Ausgangssignals; bei der das Ausgangssignal der Vergleichseinrichtung ein ersten Zustand aufweist, wenn ein Signalübergang des Signals am ersten Eingang vor einem Signalübergang des Signals am zweiten Eingang erfolgt; und bei der das Ausgangssignal der Vergleichseinrichtung einen zweiten Zustand aufweist, wenn der Signalübergang des Signals am ersten Eingang nach dem Signalübergang des Signals am zweiten Eingang erfolgt.

Vorteilhafte Aus- und Weiterbildungen sind Gegenstand abhängiger Ansprüche.

Ein zeitlicher Vergleich der Signalübergänge bzw. Schaltflanken des digitalen Signals am Ausgang der Treiberschaltung und des Taktsignals erfolgt durch die Vergleichseinrichtung, die Bestandteil der integrierten Schaltung ist. Das Ausgangssignal der Vergleichseinrichtung zeigt dabei an, welches der Signale an den Eingängen der Vergleichseinrichtung zuerst einen Signalübergang aufweist. Das Ausgangssignal der Vergleichseinrichtung liegt beispielsweise an einem Anschluß für eine externe Analyseeinrichtung an. Dort wird der Zustand eines entnommenen Ausgangssignals der Vergleichseinrichtung analysiert, woraufhin eine Einstellung der Ansteuerungsschaltung anhand des Analyseergebnisses in erforderlicher Weise erfolgen kann.

Da bei der Durchführung des zeitlichen Vergleichs des digitalen Signals und des Taktsignals die entsprechenden Signalübergänge nicht durch ein externes Testsystem direkt gemessen und analysiert werden, wird eine höhere Genauigkeit der Messung erreicht. Da die Messung direkt auf dem Chip der integrierten Schaltung erfolgt, ist die Meßgenauigkeit nicht durch die Toleranz eines externen Testsystems und der gesamten Testanordnung begrenzt.

Ein entsprechender Zustand des Ausgangssignals der Vergleichseinrichtung ist in vorteilhafter Weise in der Vergleichseinrichtung gespeichert. Dadurch kann das Ausgangssignal der Vergleichseinrichtung während eines längeren Zeitraums beispielsweise durch die externe Analyseeinrichtung entnommen werden. Das Ausgangssignal der Vergleichseinrichtung weist zudem einen statischen Zustand auf, so daß Störeinflüsse bei der Entnahme des Ausgangssignals nicht wesentlich zu einer Verfälschung des Vergleichsergebnisses führen.

Die Steuerungsfunktion der Ansteuerungsschaltung ist beispielsweise ausgehend von einem Referenzwert einstellbar. Damit der Referenzwert nur einmal eingestellt werden muß, ist es vorteilhaft, daß der Referenzwert in einer Speichereinheit der Ansteuerungsschaltung gespeichert ist. Die Speichereinheit weist dann beispielsweise programmierbare Elemente in Form von Laser Fuses oder elektrisch programmierbaren Fuses auf. Zur Einstellung des Referenzwertes werden die Laser Fuses von einem sogenannten Lasercutter programmiert.

Die integrierte Schaltung ist zum Beispiel Bestandteil eines integrierten Speichers, beispielsweise eines sogenannten SDRAMs (Synchronous DRAM). Dabei weisen insbesondere sogenannte DDR SDRAM (Double-Data-Rate SDRAMs) vergleichsweise hohe Schalt- und Zugriffsgeschwindigkeiten auf. Derartige integrierte Speicher weisen üblicherweise neben einem Taktsignal, das üblicherweise von extern zugeführt ist, ein Daten-Gültigkeitssignal bzw. Daten-Taktsignal ("Data-Strobe") auf, das an einem externen Anschluß anliegt, beispielsweise zum Auslesen von Daten des integrierten Speichers. Dieses Data-Strobe-Signal wird während eines Lesezugriffs zusammen mit auszugebenden Datensignalen vom integrierten Speicher nach extern übertragen.

Die Schaltflanken des Data-Strobe-Signals sind mittels einer sogenannten DLL-Schaltung ("Delay-Locked-Loop") mit den Schaltflanken des Taktsignals synchronisiert. Beispielsweise weist das Data-Strobe-Signal gleichzeitig eine Schaltflanke mit dem Taktsignal auf. Die DLL-Schaltung dient als Ansteuerungsschaltung für eine Treiberschaltung, die das Data-Strobe-Signal ausgibt, das beispielsweise durch eine Oszillatorschaltung erzeugt ist und am Eingang der Treiberschaltung anliegt. Über die DLL-Schaltung wird damit eine Art internes Taktsignal aus dem externen Taktsignal erzeugt, das an der Treiberschaltung anliegt. Somit ist eine bestimmte Phasenverschiebung des internen Taktsignals bzw. des Data-Strobe-Signals gegenüber dem extern zugeführten Taktsignal einstellbar.

In einer Ausführungsform der Erfindung ist der erste Eingang der Vergleichseinrichtung mit einem ersten Setz-Eingang einer Kippschaltung und der zweite Eingang der Vergleichseinrichtung mit einem zweiten Setz-Eingang der Kippschaltung verbunden. Der Ausgang der Vergleichseinrichtung ist mit einem Ausgang der Kippschaltung verbunden. Das Ausgangssignal der Kippschaltung zeigt dabei an, welches der Signale an den Setz-Eingängen zuerst einen Signalübergang aufweist.

In einer Weiterbildung der Erfindung weist die integrierte Schaltung eine Funktionseinheit auf, die mit dem Ausgang der Vergleichseinrichtung und mit der Ansteuerungsschaltung verbunden ist. Die Funktionseinheit dient zur Einstellung der Ansteuerungsschaltung anhand des Zustands des Ausgangssignals der Vergleichseinrichtung. Dadurch ist es möglich, die Ansteuerungsschaltung beispielsweise mittels elektrischer Signale einzustellen. Da die Funktionseinheit Teil der integrierten Schaltung ist, müssen keine externen Anschlüsse der integrierten Schaltung vorgesehen werden, um eine elektrische Einstellung der Ansteuerungsschaltung durchzuführen. Außerdem sind geringere Testzeiten zu erreichen, da mehrere Schaltungen parallel getrimmt werden können. Mit der Funktionseinheit können beispielsweise elektrisch programmierbare Fuses, die in der Ansteuerungsschaltung enthalten sind, programmiert werden.

In einer Weiterbildung der Erfindung weist die Funktionseinheit eine Selbsttesteinheit auf, mit der jeweils aufeinanderfolgende Zustände des Ausgangssignals der Vergleichseinrichtung analysiert werden können. Die Selbsttesteinheit dient außerdem zur schrittweisen Einstellung der Ansteuerungsschaltung anhand eines Analyseergebnisses. Mittels der Selbsttesteinheit ist folglich eine völlig eigenständige Trimmung der Ansteuerungsschaltung möglich. Die Selbsttesteinheit ist dabei nach dem Prinzip des "Built-In-Self-Test" (BIST) realisiert. Die Testzeit von mehreren zu testenden integrierten Schaltungen kann dadurch wesentlich verkürzt werden. Es können Ansteuerungsschaltungen von mehreren integrierten Schaltungen parallel getrimmt werden.

Die Erfindung wird im folgenden anhand der in der Zeichnung dargestellten Figuren näher erläutert. Es zeigen:

Figur 1       eine Ausführungsform der Erfindung,

Figur 2       eine Ausführungsform der Vergleichseinrichtung.

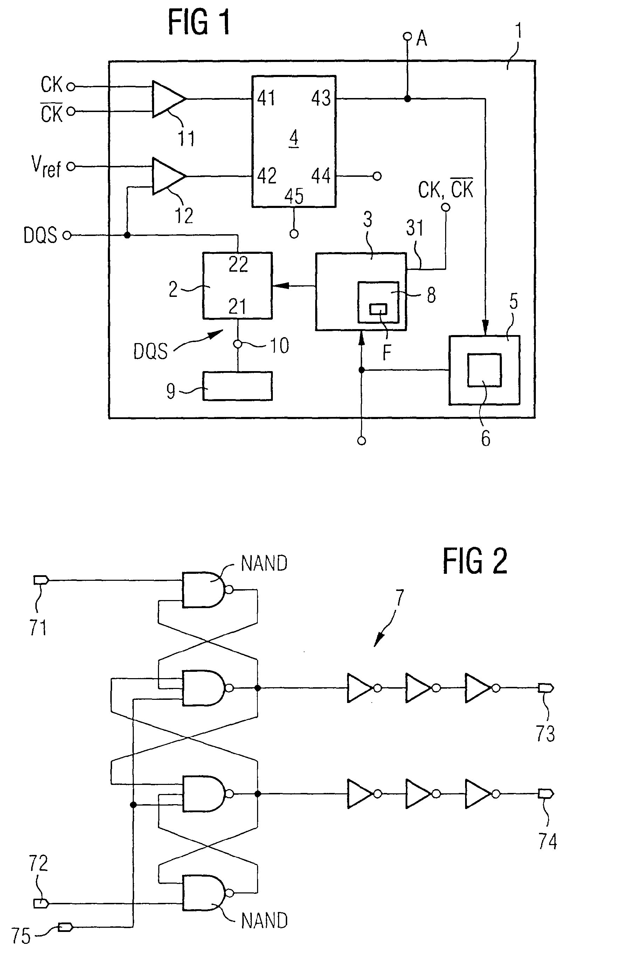

Figur 1 zeigt eine Ausführungsform der erfindungsgemäßen integrierten Schaltung, die auf einem Halbleiterchip 1 angeordnet ist. Die integrierte Schaltung ist in einer Speicherschaltung von Typ DRAM enthalten, beispielsweise in einem DDR SDRAM. Der integrierte Speicher weist ein Taktsignal CK bzw. ein dazu komplementäres Taktsignal CK auf, das über einen externen Anschluß zugeführt ist. Der Speicher weist außerdem ein sogenanntes Data-Strobe-Signal DQS auf, das über einen externen Anschluß zusammen mit auszugebenden Datensignalen des Speichers nach extern übertragen wird. Das Data-Strobe-Signal DQS fungiert dabei als ein Daten-Gültigkeitssignal bzw. Daten-Taktsignal des Speichers zum Auslesen von Daten des Speichers.

Die integrierte Schaltung weist weiterhin eine Ansteuerungsschaltung 3 auf, die als DLL-Schaltung bezeichnet wird. Der Anschluß 10 für das Signal DQS ist an eine Oszillatorschaltung 9 angeschlossen. Die Ansteuerungsschaltung 3 weist einen Eingang 31 auf für das Taktsignal CK bzw. $\overline{CK}$. Die Ansteuerungsschaltung 3 dient zur Ansteuerung einer steuerbaren Treiberschaltung 2, die einen Eingang 21 aufweist, der mit einem Anschluß 10 für das Signal DQS verbunden ist, und einen Ausgang 22 zur Ausgabe des Signals DQS. Die Ansteuerungsschaltung 3 erzeugt eine Art internes Taktsignal aus dem externen Taktsignal CK bzw. $\overline{CK}$ mit einer bestimmten Phasenverschiebung gegenüber diesem. Die Treiberschaltung 2 wird damit von dem internen Taktsignal angesteuert. Mittels der Ansteuerungsschaltung 3 bzw. DLL-Schaltung werden also Signalübergänge des Signals DQS mit Signalübergängen des Taktsignals CK bzw. CK abgestimmt, bzw. die Signalübergänge werden miteinander synchronisiert. Es ist eine bestimmte Phasenverschiebung des Signals DQS gegenüber dem extern zugeführten Taktsignal CK bzw. $\overline{CK}$ einstellbar. Das Signal DQS wird während eines Lesezugriffs zusammen mit auszugebenden Datensignalen vom integrierten Speicher nach extern übertragen.

Die integrierte Schaltung nach Figur 1 weist weiterhin eine Vergleichseinrichtung 4 auf, die einen ersten Eingang 41 für das Taktsignal CK bzw. $\overline{CK}$ und einen zweiten Eingang 42 aufweist, der mit dem Ausgang 22 der Treiberschaltung 2 verbunden ist. Ein Ausgang 43 der Vergleichseinrichtung 4 dient zur Ausgabe eines Ausgangssignals A. Das Ausgangssignal A weist einen ersten Zustand "H" auf, wenn ein Signalübergang des Signals am Eingang 41 vor einem Signalübergang des Signals am Eingang 42 erfolgt. Dementsprechend weist das Ausgangssignal A einen zweiten Zustand "L" auf, wenn der Signalübergang des Signals am Eingang 41 nach dem Signalübergang des Signals am Eingang 42 erfolgt. Die Vergleichseinrichtung 4 weist einen weiteren Ausgang 44 auf, der ein Signal aufweist, das über entsprechende Zustände die umgekehrte Reihenfolge der Signalübergänge anzeigt. Ein Rücksetzen der Vergleichseinrichtung 4 ist mit einem entsprechenden Signal an einem Anschluß 45 möglich.

Das Taktsignal CK bzw. $\overline{CK}$ wird über einen Differenzverstärker 11 mit dem Eingang 41 der Vergleichseinrichtung 4 verbunden. Das Signal DQS ist ebenfalls über einen Differenzverstärker 12, an dem ein Referenzpotential $V_{ref}$ anliegt, an den Eingang 42 der Vergleichseinrichtung 4 geschaltet.

Die integrierte Schaltung weist weiterhin eine Funktionseinheit 5 auf, die mit dem Ausgang 43 der Vergleichseinrichtung 4 und mit der Ansteuerungsschaltung 3 verbunden ist. Die Funktionseinheit 5 dient zur Einstellung der Ansteuerungsschaltung 3 anhand des Zustands des Ausgangssignals A der Vergleichseinrichtung 4. Durch die Funktionseinheit 5 ist eine Einstellung der Ansteuerungsschaltung 3 mittels eines elektrischen Signals möglich.

In der Ansteuerungsschaltung 3 ist ein Referenzwert in einer Speichereinheit 8 gespeichert. Die Steuerungsfunktion der Ansteuerungsschaltung 3 ist ausgehend von dem gespeicherten Referenzwert einstellbar. Die Speichereinheit 8 weist programmierbare Elemente F in Form von programmierbaren Fuses auf. Wird eine Programmierung der Speichereinheit 8 durch die Funktionseinheit 5 durchgeführt, so sind die programmierbaren Fuses F in geeigneter Weise als elektrisch programmierbare Fuses ausgeführt.

In einer Weiterbildung der integrierten Schaltung weist die Funktionseinheit 5 eine Selbsttesteinheit 6 auf zur Analyse von jeweils aufeinanderfolgenden Zuständen des Ausgangssignals A der Vergleichseinrichtung 4. Mittels der Selbsttesteinheit 6 ist ein eigenständiges Trimmen der Ansteuerungsschaltung 3 möglich. Es ist nicht mehr erforderlich, das Vergleichsergebnis über einen externen Anschluß zu entnehmen bzw. die Einstellung der Ansteuerungsschaltung 3 über einen externen Anschluß durchzuführen. Die Selbsttesteinheit 6 ist geeignet, eine schrittweise Einstellung der Ansteuerungsschaltung 3 anhand eines Analyseergebnisses vorzunehmen.

In Figur 2 ist eine Ausführungsform der Vergleichseinrichtung 4 dargestellt. Diese weist eine Kippschaltung 7 auf mit einem ersten Setz-Eingang 71 und einem zweiten Setz-Eingang 72. Der Setz-Eingang 71 ist mit dem Eingang 41 der Vergleichseinrichtung 4 verbunden, der Setz-Eingang 72 ist mit dem Eingang 42 der Vergleichseinrichtung 4 verbunden. Die Kippschaltung 7 weist einen Ausgang 73 auf, der mit dem Ausgang 43 der Vergleichseinrichtung 4 verbunden ist. Der weitere Ausgang 44 der Vergleichseinrichtung 4 ist mit einem Ausgang 74 der Kippschaltung 7 verbunden. Ein Rücksetz-Eingang 75 der Kippschaltung 7 ist mit dem Anschluß 45 der Vergleichseinrichtung 4 verbunden. Das Ausgangssignal am Ausgang 73 der Kippschaltung 7 zeigt an, welches der Signale an den Setz-Eingängen 71 bzw. 72 zuerst einen Signalübergang aufweist. Bis zum Rücksetzen der Kippschaltung 7 ist das jeweilige Ausgangssignal am Ausgang 73 gespeichert.

## Patentansprüche

1. Integrierte Schaltung

   - mit einem Anschluß (10) für ein digitales Signal (DQS),
   - mit einer steuerbaren Treiberschaltung (2), die einen Eingang (21) aufweist, der mit dem Anschluß (10) für das digitale Signal (DQS) verbunden ist, und einen Ausgang (22) zur Ausgabe des digitalen Signals (DQS),
   - mit einer Ansteuerungsschaltung (3), die einen Eingang (31) für ein Taktsignal (CK) aufweist, zur Ansteuerung der Treiberschaltung (2) in Abhängigkeit des Taktsignals (CK),

**dadurch gekennzeichnet, daß**

- die integrierte Schaltung eine Vergleichseinrichtung (4) aufweist, die einen ersten Eingang (41) für das Taktsignal (CK) und einen zweiten Eingang (42) aufweist, der mit dem Ausgang (22) der Treiberschaltung (2) verbunden ist, und die einen Ausgang (43) aufweist zur Ausgabe eines Ausgangssignals (A),
- das Ausgangssignal (A) der Vergleichseinrichtung (4) einen ersten Zustand aufweist, wenn ein Signalübergang des Signals (CK) am ersten Eingang (41) vor einem Signalübergang des Signals (DQS) am zweiten Eingang (42) erfolgt,
- das Ausgangssignal (A) der Vergleichseinrichtung (4) einen zweiten Zustand aufweist, wenn der Signalübergang des Signals (CK) am ersten Eingang (41) nach dem Signalübergang des Signals (DQS) am zweiten Eingang (42) erfolgt.

2. Integrierte Schaltung nach Anspruch 1, **dadurch gekennzeichnet, daß** die Zustände des Ausgangssignals (A) der Vergleichseinrichtung (4) in der Vergleichseinrichtung (4) gespeichert sind.

3. Integrierte Schaltung nach einem der vorhergehenden Ansprüche, **dadurch gekennzeichnet, daß**

- der erste Eingang (41) der Vergleichseinrichtung (4) mit einem ersten Setz-Eingang (71) einer Kippschaltung (7) und der zweite Eingang (42) der Vergleichseinrichtung (4) mit einem zweiten Setz-Eingang (72) der Kippschaltung (7) verbunden sind,
- der Ausgang (43) der Vergleichseinrichtung (4) mit einem Ausgang (73) der Kippschaltung (7) verbunden ist,
- das Ausgangssignal (A) der Vergleichseinrichtung (4) anzeigt, welches der Signale an den Setz-Eingängen (41, 42) zuerst einen Signalübergang aufweist.

4. Integrierte Schaltung nach einem der vorhergehenden Ansprüche, **dadurch gekennzeichnet, daß** die integrierte Schaltung eine Funktionseinheit (5) aufweist, die mit dem Ausgang (43) der Vergleichseinrichtung (4) und mit der Ansteuerungsschaltung (3) verbunden ist, zur Einstellung einer Steuerungsfunktion der Ansteuerungsschaltung (3) anhand des Zustands des Ausgangssignals (A) der Vergleichseinrichtung (4).

5. Integrierte Schaltung nach Anspruch 4, **dadurch gekennzeichnet, daß** die Funktionseinheit (5) eine Selbsttesteinheit (6) aufweist zur Analyse von jeweils aufeinanderfolgenden Zuständen des Ausgangssignals (A) der Vergleichseinrichtung (4) und zur schrittweisen Einstellung der Ansteuerungsschaltung (3) anhand eines Analyseergebnisses.

6. Integrierte Schaltung nach einem der vorhergehenden Ansprüche, **dadurch gekennzeichnet, daß**

- eine Steuerungsfunktion der Ansteuerungsschaltung (3) ausgehend von einem Referenzwert einstellbar ist,
- die Ansteuerungsschaltung (3) eine Speichereinheit (8) zur Speicherung des Referenzwertes aufweist.

7. Integrierte Schaltung nach Anspruch 6, **dadurch gekennzeichnet, daß** die Speichereinheit (8) programmierbare Elemente (F) in Form von programmierbaren Fuses aufweist.

8. Integrierte Schaltung nach einem der vorhergehenden Ansprüche, **dadurch gekennzeichnet, daß** am Anschluß (10) für das digitale Signal (DQS) eine Oszillatorschaltung (9) angeschlossen ist.

9. Integrierte Schaltung nach einem der vorhergehenden Ansprüche, **dadurch gekennzeichnet, daß** die integrierte Schaltung in einer Speicherschaltung vom Typ DRAM enthalten ist.

10. Integrierte Schaltung nach Anspruch 9, **dadurch gekennzeichnet, daß** das digitale Signal (DQS) ein Daten-Gültigkeitssignal und ein Daten-Taktsignal ist zum Auslesen von Daten der Speicherschaltung.

## FIG 1

## FIG 2